# EUROPÄISCHE PATENTSCHRIFT

(11) **EP 3 167 329 B1**
(45) Veröffentlichungstag und Bekanntmachung des Hinweises auf die Patenterteilung: **10.07.2019**
(21) Anmeldenummer: 15730201.9
(22) Anmeldetag: 23.06.2015
(51) Int. Cl.: G02B 19/00, G02B 7/02, H01S 5/022, G02B 27/10

(54) **VORRICHTUNG ZUR ERZEUGUNG VON LICHT MIT MEHREREN WELLENLÄNGEN, VERFAHREN ZUR HERSTELLUNG EINER VORRICHTUNG, VERWENDUNG EINES POSITIONIERUNGSMODULS UND VERFAHREN ZUR KOMBINATION VON LICHTSTRAHLEN**
APPARATUS FOR GENERATING LIGHT HAVING A PLURALITY OF WAVELENGTHS, METHOD FOR MANUFACTURING AN APPARATUS, USE OF A POSITIONING MODULE AND METHOD FOR COMBINING LIGHT BEAMS
DISPOSITIF POUR GÉNÉRER DE LA LUMIÈRE PRÉSENTANT DIFFÉRENTES LONGUEURS D'ONDE, PROCÉDÉ POUR PRODUIRE UN DISPOSITIF, UTILISATION D'UN MODULE DE POSITIONNEMENT ET PROCÉDÉ POUR COMBINER DES FAISCEAUX LUMINEUX

(30) Priorität: 08.07.2014 EP 14176182
(43) Veröffentlichungstag der Anmeldung: 17.05.2017
(73) Patentinhaber: Fisba AG, 9016 St. Gallen (CH)
(72) Erfinder: MOSER, Hansruedi, CH-9452 Hinterforst (CH); WÄSPI, Marcel, CH-9312 Häggenschwil (CH); SPRING, Patrick, CH-9403 Goldach (CH)
(74) Vertreter: Hepp Wenger Ryffel AG
(86) Internationale Anmeldenummer: PCT/EP2015/064025
(87) Internationale Veröffentlichungsnummer: WO 2016/005179

(56) Entgegenhaltungen:
- DE-A1-102011 005 014
- JP-A- H11 142 754
- JP-A- 2012 247 529
- US-A1- 2006 119 805
- US-A1- 2011 063 871
- US-A1- 2011 304 828
- US-A1- 2012 294 326
- US-A1- 2014 016 106
- US-A1- 2014 029 076

## Beschreibung

Die Erfindung betrifft eine Vorrichtung zur Erzeugung von Licht mit mehreren Wellenlängen, ein Verfahren zur Herstellung einer Vorrichtung, die Verwendung eines Positionierungsmoduls und ein Verfahren zur Kombination von Lichtstrahlen.

Es sind bereits Projektionsmodule bekannt, die in miniaturisierter Bauart Licht mit verschiedenen Farben projizieren können. Eine derartige Projektionsvorrichtung ist beispielsweise aus der WO 2013/178280 bekannt, in der offenbart wird, dass drei Lichtquellen Licht emittieren, das Licht in einem Strahlkombinierer zu einem Strahl kombiniert wird und dann über einen MEMS-Spiegel auf eine Projektionsfläche projiziert wird. Weiterhin ist hier eine optische Modifiziervorrichtung ausgebildet, die die einzelnen Farben zu einem runden Strahldurchmesser modifiziert. Eine derartige Vorrichtung ist sehr komplex und mit ihren vielen Bauteilen nur sehr schwer miniaturisierbar und gleichzeitig genau herzustellen. Weiterhin ist die Lichtausbeute schlecht.

US 2014/029076 A1 zeigt ein Lichtmodul, bei der eine Linse in einer speziell geformten Linsenhaltung angebracht ist, welche auf einer mit einer V-förmigen Ausnehmung versehenen Aufnahme befestigt wird. Die Linsenhalterung kann in Aufnahme ausgerichtet und anschliessend fixiert werden.

Aus US 2014/016106 A1 und JP 2012 247529 sind Lichtmodule bekannt, bei denen eine Kollimierungslinse in einer Linsenhalterungen angeordnet ist, die bezüglich einer Lichtquelle verschiebbar ist, sodass der Abstand zwischen Lichtquelle und Kollimierungslinse eingestellt werden kann. Die Positionierungsmöglichkeiten der Kollimierungslinse sind ansonsten begrenzt.

Aus der WO 2014/023322 ist weiterhin eine Projektionsvorrichtung bekannt, in der Laserdioden parallel nebeneinander angeordnet sind, wobei die Laserdioden in Aufnahmen eingeklebt sind. Ungenauigkeiten bei der Ausrichtung der Laserdioden werden so ausgeglichen, dass erst die Laserdioden fixiert werden, und danach Spiegel einerseits zur Kombination der Lichtstrahlen und zur Korrektur der Ausrichtungsfehler der Laserdioden verwendet werden. Dieses Verfahren ist aufwendig in der Durchführung und ungenau in der Ausrichtung der Dioden.

US 2012/294326 A1 zeigt ein Verfahren zur Herstellung einer Laservorrichtung, wobei eine Kollimierungslinse so positioniert wird, dass ihre optische Achse der Laserachse entspricht und dann auf einem Linsenhalter befestigt wird. Daraufhin kann die Linse mit dem Linsenhalter axial entlang der optischen Achse bewegt werden.

DE 102011005104 A1 offenbart ein Verfahren zur Herstellung einer Laservorrichtung, wobei der Abstand einer Kollimierungslinse durch einen zweiteiligen Linsenhalter eingestellt werden kann. Hierfür umfasst der Linsenhalter zwei Teile, die jeweils schräge Stirnseiten umfassen und relativ zueinander verschiebbar sind.

US 2011/063871 A1 offenbart ein Multi-Wellenlängen Licht-Emitter, wobei drei Lichtquellen vor jeweils einer Linse angeordnet sind. Die Linsen sind auf einem Würfel angeordnet.

US 2006/119805 A1 offenbart ein Projektionsmodul, in welchem die mechanische Achse der Fokussierlinse mit der optischen Achse des Laserstrahls abgeglichen wird.

US 2011/304828 A1 offenbart ein passives Justierungsverfahren für einen Mikroprojektor. Es werden Referenzflächen von je zwei aufeinander treffenden Komponenten genutzt, um eine exakte Ausrichtung zu erzielen.

JP H11 142754 zeigt eine Kollimierungslinse, die exzentrisch in einem drehbaren Gehäuse angeordnet ist, sodass sich die Linse gegenüber einem Laser durch Drehen des Gehäuses ausrichten lässt.

Es ist daher Aufgabe der vorliegenden Erfindung die Nachteile des Standes der Technik zu vermeiden und insbesondere eine Vorrichtung und ein Verfahren zu schaffen, mit der eine möglichst gute Überlagerung der einzelnen Farben, eine hohe Lichtausbeute sowie eine vereinfachte Herstellung möglich ist.

Die Aufgabe wird durch den kennzeichnenden Teil der unabhängigen Ansprüche gelöst.

Insbesondere wird die Aufgabe durch eine Vorrichtung zur Erzeugung von Licht mit mehreren Wellenlängen gelöst, die ein Gehäuse umfasst. Im Gehäuse sind Lichtquellen angeordnet, insbesondere Laserdioden. Bevorzugt handelt es sich um drei Lichtquellen mit jeweils unterschiedlichen Wellenlängen. Weiterhin umfasst das Gehäuse Kollimierungslinsen zum Kollimieren eines Lichtstrahls, der aus diesen Lichtquellen austritt. Zusätzlich umfasst die Vorrichtung Strahlführungselemente, um die Lichtstrahlen zusammenzuführen. Die Kollimierungslinsen sind in einem Positionierungsmodul angeordnet, welches eine Positionierung der Kollimierungslinsen in unterschiedlichen Positionen innerhalb des Positionierungsmoduls im Herstellungsprozess der Vorrichtung ermöglicht.

Eine derartige Vorrichtung ist leicht und automatisiert herstellbar und führt zu einer sehr genauen Überlagerung der einzelnen Lichtstrahlen.

Bevorzugt werden in der Vorrichtung genau drei Lichtquellen mit den Farben rot, grün und blau. Weiterhin ist es möglich eine vierte Lichtquelle hinzuzufügen, insbesondere eine zweite grüne Lichtquelle, um die Lichtintensität in dieser bestimmten Farbe zu optimieren.

Zwischen Lichtquelle und Kollimierungslinse ist bevorzugt keine Blende angeordnet, um die volle Lichtleistung der Lichtquelle nutzen zu können.

Ein erfindungsgemässes Positionierungsmodul ist so ausgebildet, dass es eine einfache Positionierung der Kollimierlinse erlaubt, während die Lichtquelle bereits im Gehäuse befestigt ist. Das Positionierungsmodul ist bevorzugt ein Teil der Vorrichtung und verbleibt auch nach der Herstellung im Gehäuse. Das Positionierungsmodul weist bevorzugt eine Dimensionierung von maximal 3x3x3 mm auf.

Das Positionierungsmodul kann ein Würfel oder ein sechsseitiges Prisma sein. Möglich wären auch ein acht- oder mehrseitiges Prisma. Die einzelnen Mantelflächen des Prismas dienen hierbei als Standflächen für das Prisma, so dass beispielsweise bei einem sechseitigen Prisma sechs Standflächen ausgebildet sind.

Ein erfindungsgemässes Positionierungsmodul hat eine Frontseite und eine Rückseite, wobei die Frontseite zu der Lichtquelle hin orientiert ist und die Rückseite von der Lichtquelle weg. Front- und Rückseite sind durch Seitenflächen verbunden, auf denen das Positionierungsmodul aufsetzbar ist. Zwischen Front- und Rückseite ist eine Kollimierungslinse angeordnet, so dass das Licht aus der Lichtquelle durch die Kollimierungslinse durchstrahlbar ist.

Die Kollimierungslinsen sind in dem Positionierungsmodul angebracht und werden mit dem Positionierungsmodul im Lichtstrahl vor den Lichtquellen positioniert.

Ein derartiges Positionierungsmodul ermöglicht ein einfaches Positionieren der Kollimierungslinsen, wobei gleichzeitig genügend Fläche zum genauen Positionieren und fixieren der Position vorhanden ist.

Beim Positionieren des Positionierungsmoduls ist es gleichzeitig möglich, eventuelle Ausrichtungsfehler der Lichtquellen zumindest teilweise auszugleichen.

Die Kollimierlinse im Positionierungsmodul kann exzentrisch angeordnet sein, insbesondere bezogen auf die Seitenflächen des Positionierungsmoduls.

Durch eine exzentrische Anordnung der Linse im Positionierungsmodul kann die Position der Linse durch Drehen des Positionierungsmoduls und Anordnen auf einer anderen Seitenfläche eine Korrektur eines eventuellen Ausrichtungsfehlers der Lichtquelle bewirken.

Das Positionierungsmodul kann aus Metall, insbesondere Aluminium oder Stahl, oder auch bereits vollständig aus Glas gefertigt sein.
Das Positionierungsmodul ist bevorzugt in der Vorrichtung eingeklebt, wobei bei der Dosierung des Klebstoffs eine Schrumpfung bei der Aushärtung bzw. Trocknung berücksichtigt wird. Die Strahlführungselemente können dichroitische Spiegel umfassen, bevorzugt einen dichroitischen Spiegel pro Lichtquelle.

Mit dichroitischen Spiegeln lassen sich die einzelnen Lichtstrahlen an die richtige Position führen, ausrichten und gleichzeitig zu einem Strahl vereinigen.

Die Strahlführungselemente können ein Prismenteleskop umfassen.

Mit einem Prismenteleskop lässt sich der Strahldurchmesser des Lichtstrahls optimieren. Bevorzugt wird ein Prismenteleskop für den bereits kombinierten Lichtstrahl nach den dichroitischen Spiegeln verwendet. Es ist jedoch auch denkbar pro Lichtquelle ein Prismenteleskop vor den dichroitischen Spiegeln zu verwenden. Dies ist jedoch aufgrund des benötigten Platzes nachteilig für eine miniaturisierte Ausführung. Das Prismenteleskop optimiert das Verhältnis der beiden Achsen das Strahlquerschnitts in Richtung 1, bevorzugt auf einen Bereich von 0.5 bis 0.8.

Das Prismenteleskop kann aus einzelnen Prismen bestehen, die zur optimalen Ausrichtung der Lichtstrahlen einzeln positionierbar sind.

Somit entsteht ein genau überlagerter, der runden Querschnittsform möglichst angenäherter Strahl.

Eine der Lichtquellen kann nach der Kollimierungslinse in Strahlausbreitungsrichtung eine Verzögerungsplatte, bevorzugt eine Lambda halbe λ/2 (Lambda halbe)-platte, umfassen.

Somit lässt sich, insbesondere bei zwei gleichfarbigen Lichtquellen, die Polarisation des ausgesendeten Lichtes ändern, sodass zwei Strahlen gleicher Wellenlänge übereinander gelegt werden können. Mit den dichroitischen Spiegeln werden dann die weiteren Wellenlänge ebenfalls in den Strahl kombiniert.

Das Gehäuse weist bevorzugt eine maximale Ausdehnung von 5x15x25 mm (HxBxL) auf. Das Gehäuse besteht bevorzugt aus Aluminium, Stahl oder Kupfer, welches zum Löten geeignet ist.

Zur Lösung der Aufgabe führt weiterhin ein Verfahren zur Herstellung einer Vorrichtung, insbesondere wie vorhergehend beschrieben.

Das Verfahren umfasst die folgenden Schritte:
- Befestigen, bevorzugt einpressen, von mindestens drei Lichtquellen in ein Gehäuse; bei den Lichtquellen handelt es sich insbesondere um Laserdioden;
- Bereitstellen eines Positionierungsmoduls;
- Positionieren von Kollimierungslinsen in einem Lichtstrahl, der aus den jeweiligen Lichtquellen austritt, mit Hilfe des Positionierungsmoduls;
- Verbinden von Positionierungsmodul und Gehäuse, insbesondere als dauerhafte Verbindung;
- Positionieren von Strahlführungselementen in einem Lichtstrahl nach den Kollimierungslinsen zum Zusammenführen der einzelnen Lichtstrahlen zu einem gemeinsamen Lichtstrahl.

Ein derartiges Verfahren kann automatisiert durchgeführt werden und ermöglicht eine genaue Ausrichtung der einzelnen Lichtstrahlen sowie eine optimierte Lichtausbeute.

Das Positionierungsmodul ermöglicht eine Positionierung der Kollimierungslinse in drei Dimensionen, namentlich Position entlang der Ausbreitungsrichtung des Lichtes aus der Lichtquelle (Z-Richtung), senkrecht zur Ausbreitungsrichtung (X-Richtung) sowie senkrecht zur Ausbreitungsrichtung und zur X-Richtung (Y-Richtung). Die Y-Richtung wird auch als Höhe bezeichnet. Die Positionierung in Y-Richtung ist durch eine exzentrisch angeordnete Kollimierungslinse in sehr begrenztem Masse möglich, ohne dass der Strahl zu asymmetrisch wird.
Die jeweiligen Positionierungsmodule können eingeklebt werden. Bevorzugt werden die Positionierungsmodule zunächst positioniert und dann eingeklebt.

Ein eingeklebtes Positionierungsmodul lässt sich flexibel positionieren und fixieren. Weiterhin ermöglicht eine genaue Kenntnis des Klebstoffs auch die Berücksichtigung der benötigten Menge zur genauen Höhenpositionierung der Kollimierungslinse.

Beim Einkleben der Positionierungsmodule kann die Menge des Klebstoffs und/oder die Klebspaltgrösse so gewählt werden, dass ein beim Aushärten des Klebstoffs auftretender Schrumpf berücksichtigt wird.

Somit lässt sich die Position des Positionierungsmoduls und damit der Kollimierungslinse sehr genau bestimmen und einstellen.

Der Klebstoff kann Epoxy-Kleber sein.

Die Strahlführungselemente können dichroitische Spiegel umfassen, wobei die Positionierungselemente so positioniert werden, dass eventuelle vorhandene Höhenunterschiede zwischen den einzelnen Laserstrahlen ausgeglichen werden. Hierzu werden die Positionierungselemente so ausgerichtet, dass alle Lichtstrahlen höhengleich auf den Spiegeln angeordnet sind.

Durch das Positionieren der Spiegel und Positionierungselemente ist es möglich, Ungenauigkeiten in allen drei Richtungen (X, Y, Z-Richtung) auszugleichen. Insbesondere ein Ausgleichen der Höhenunterschiede ist durch die Positionierung der Positionierungselemente realisierbar. Somit ist die Erzielung eines sehr genau überlagerten gemeinsamen Strahls möglich.

Zur Lösung der Aufgabe führt weiterhin die Verwendung eines Positionierungsmoduls zur Positionierung von Linsen, insbesondere Kollimierungslinsen.

Die unabhängige Positionierung des Positionierungsmoduls mit den Kollimierungslinsen führt zu einer einfachen Möglichkeit Ausrichtungsfehler von Lichtquellen zu korrigieren und eine exakte und stabile Kollimation zu erreichen.

Zur Lösung der Aufgabe führt weiterhin ein Verfahren zur Kombination von Lichtstrahlen, wobei die Lichtstrahlen aus mindestens zwei Lichtquellen, bevorzugt Laserdioden, mit je einer Kollimierungslinse kollimiert werden. Die Kollimierungslinsen sind in je einem Positionierungsmodul angeordnet. Die kollimierten Strahlen werden zu einem kombinierten Strahl durch Strahlführungselemente zusammengeführt.

Ein derartiges Verfahren ist einfach durchzuführen und führt zu einem kombinierten Strahl mit hoher Lichtintensität und einer grösstmöglichen Überdeckung der einzelnen Farben aus den Lichtquellen.

Zur Lösung der Aufgabe führt weiterhin eine Vorrichtung zur Erzeugung von Licht mit mehreren Wellenlängen, die ein Gehäuse und im Gehäuse angeordnete Lichtquellen, insbesondere Laserdioden, umfasst. Bevorzugt sind drei Lichtquellen mit jeweils unterschiedlichen Wellenlängen ausgebildet. Die Vorrichtung umfasst weiterhin Kollimierungslinsen, bevorzugt Kollimierlinsen in einem Positionierungsmodul, zum Kollimieren eines Lichtstrahls, der aus den Lichtquellen austritt und Strahlführungselemente, um die Lichtstrahlen zusammenzuführen. Die Lichtquellen sind im Gehäuse durch eine Presspassung festgelegt.

Eine derartige Vorrichtung führt zu einem optimalen Wärmeübergang der Wärme, die von den Lichtquellen erzeugt wird, in das umgebende Gehäuse. Die Lichtquellen werden in das Gehäuse eingepresst und nicht mehr justiert. Derartig eingebrachte Lichtquellen sind sehr schnell montierbar und es sind keine aufwendigen Kleb-, Füll-, und Justierprozesse durchzuführen.

Bevorzugt weist eine derartige Vorrichtung ein Positionierungsmodul wie vorhergehend beschrieben auf.

Die Strahlführungselemente umfassen bevorzugt ein Prismenteleskop wie vorhergehend beschrieben und dichroitische Spiegel, bevorzugt ein dichroitischer Spiegel pro Lichtquelle.

Die Vorrichtung kann eine Verzögerungsplatte umfassen, die die Polarisation von Licht aus einer Lichtquelle nach der Kollimierlinse ändert.

Somit lassen sich auch mehrere Lichtquellen mit einer Farbe durch die dichroitischen Spiegel kombinieren.

Nachfolgend wird die Erfindung anhand von Figuren in Ausführungsbeispielen näher erläutert. Hierbei zeigt:
- Figur 1:: Perspektivische Darstellung eines Gehäuses mit Positionierungsmodulen,
- Figur 2:: Eine schematische Draufsicht einer erfindungsgemässen Vorrichtung,
- Figur 3:: Ein Querschnitt durch ein Positionierungsmodul,
- Figur 4:: Eine schematische Draufsicht auf eine erfindungsgemässe Vorrichtung gemäss einer weiteren Ausführungsform,
- Figur 5:: Eine schematische Draufsicht einer erfindungsgemässen Vorrichtung zur Faser-Einkopplung,
- Figur 6:: Eine perspektivische, drei-dimensionale Ansicht einer erfindungsgemässen Vorrichtung;
- Figur 7:: Einen Querschnitt durch ein Positionierungsmodul.

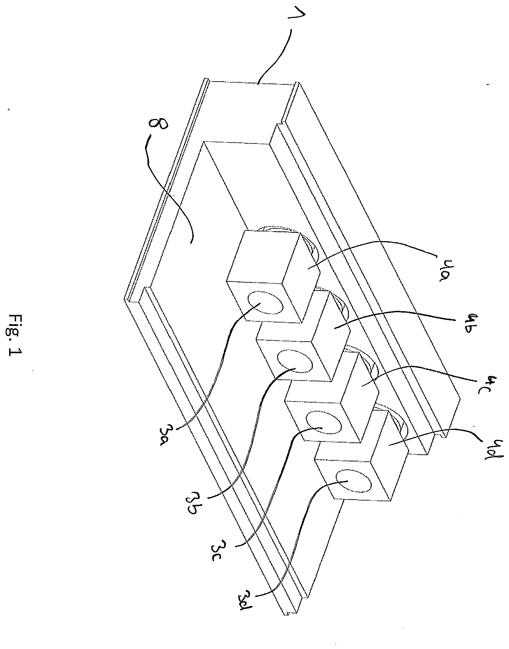

Figur 1 zeigt eine erfindungsgemässe Vorrichtung mit einem Gehäuse 1. In dem Gehäuse 1 sind vier Laserdioden eingepresst (nicht sichtbar). Vor den Laserdioden sind vier Positionierungsmodule 4 angeordnet. Die Positionierungsmodule 4 weisen je eine Kollimierungslinse 3 auf. Die Positionierungsmodule 4 werden zur Ausrichtung der Lichtstrahlen aus den Laserdioden verwendet. Hierzu sind die Öffnungen, in denen die Kollimierungslinsen 3 angeordnet sind, exzentrisch im Positionierungsmodul 4 angeordnet. Weiterhin kann der Abstand zwischen Laserdiode und Positionierungsmodul beim Positionieren des Positionierungsmoduls 4 angepasst werden. Die Positionierungsmodule 4 sind am Boden 9 des Gehäuses 1 festgeklebt. Die Menge des Klebers ist so dimensioniert, dass auch eine Korrektur der Höhe des Positionierungsmoduls 4 über dem Gehäuse 1 eingestellt wird, wobei ein Schrumpf des Klebstoffs einberechnet ist. Im fertigen Zustand weist das Gehäuse 1 ausserdem einen Deckel (nicht dargestellt) auf.

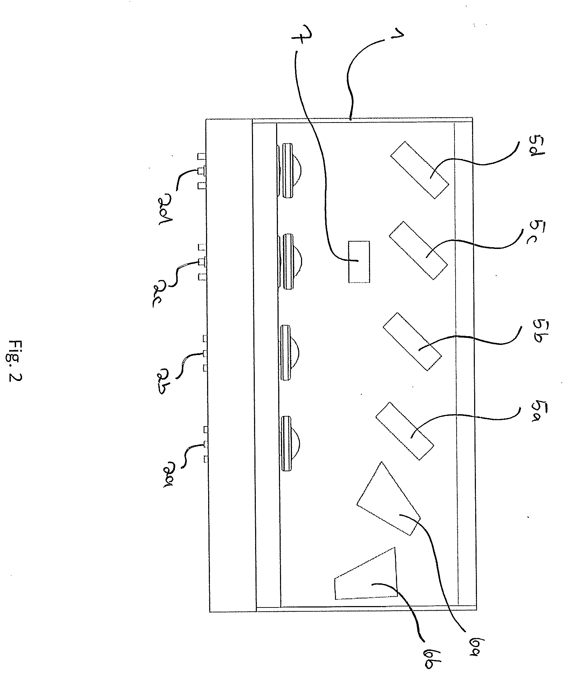

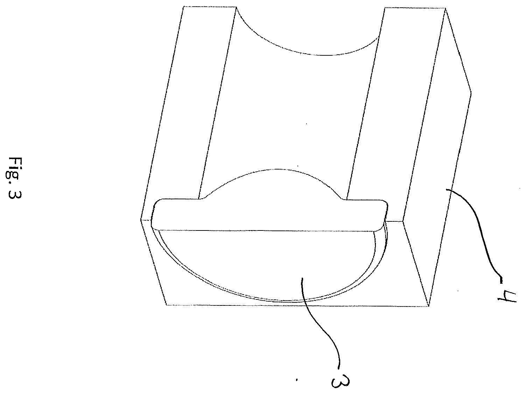

Figur 2 zeigt eine Draufsicht einer Ausführungsform der erfindungsgemässen Vorrichtung. Die vier Lichtquellen 2 emittieren einen Lichtstrahl auf die dichroitischen Spiegel 5. Die dichroitischen Spiegel 5 sind nach dem Einpressen der Lichtquellen 2 in das Gehäuse 1 am Gehäuse 1 befestigt worden. Somit haben auch die dichroitischen Spiegel 5 nicht denselben Abstand zu den jeweiligen Lichtquellen 2. In dieser Ausführungsform sind exemplarisch zwei rote Lichtquellen 2c, 2d ausgebildet. Eine der roten Lichtquellen 2c wird daher durch eine Verzögerungsplatte 7 in ihrer Polarisation verändert. Somit kann der dichroitische Spiegel 5c das rote Licht aus der Lichtquelle 2d passieren lassen und gleichzeitig das rote Licht aus der Quelle 2c reflektieren. Das Licht aus sämtlichen Lichtquellen 2 wird weiter durch das Prismenteleskop 6 zu einem runden Strahl geformt. Das Prismenteleskop 6 besteht aus einem ersten Prisma 6a und einem zweiten Prisma 6b, die unabhängig voneinander verstellt werden können. Zur Verdeutlichung sind die Linsen vor den Lichtquellen 2 ohne Positionierungmodul 4 (siehe Figur 3) dargestellt. Die Kollimation in der Ausführungsform wird jedoch immer mit Positionierungsmodulen 4 durchgeführt.

Figur 3 zeigt einen Schnitt durch ein Positionierungsmodul 4 mit einer Kollimierlinse 3. Die Kollimierlinse 3 wird zum Kollimieren des Lichtstrahls aus den Lichtquellen 2 (siehe Figur 1 und 2) verwendet. Das Positionierungsmodul 4 ermöglicht eine einfache Positionierung der Kollimierlinse 3. Weiterhin ist die Kollimierlinse 3 exzentrisch in dem Positionierungsmodul 4 angeordnet, sodass, in diesem Falle eines würfelförmigen Positionierungsmoduls 4, vier unterschiedliche Positionen der Linse möglich sind.

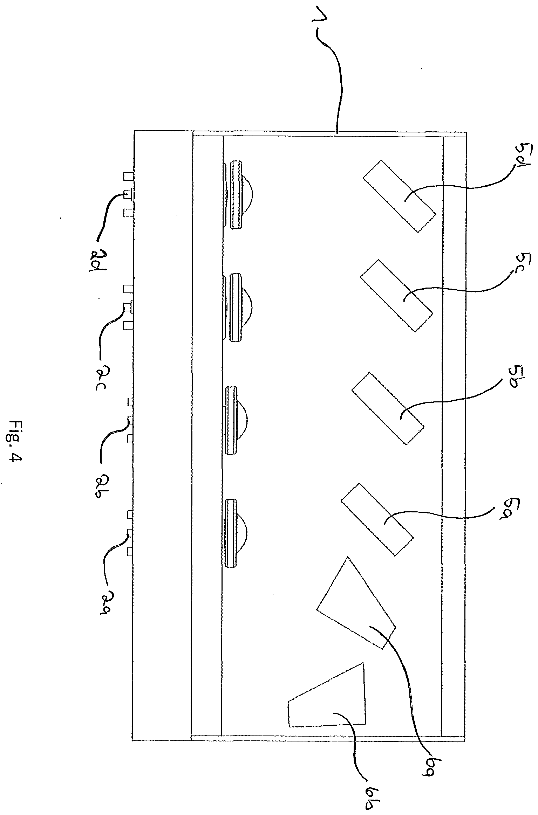

Figur 4 zeigt eine Draufsicht auf eine alternativen Ausführungsform der erfindungsgemässen Vorrichtung. Die Ausführungsform der Figur 4 entspricht der Ausführungsform der Figur 2 ohne die Verwendung einer Verzögerungsplatte 7. Die Lichtquellen 2 emittieren in dieser Ausführungsform alle unterschiedliche Wellenlängen, da ein dichroitischer Spiegel 5 nicht gleichzeitig durchlässig und reflektierend für dieselbe Farbe ausgebildet sein kann. Sämtliche Strahlführungselemente sind am Gehäuse 1 festgeklebt.

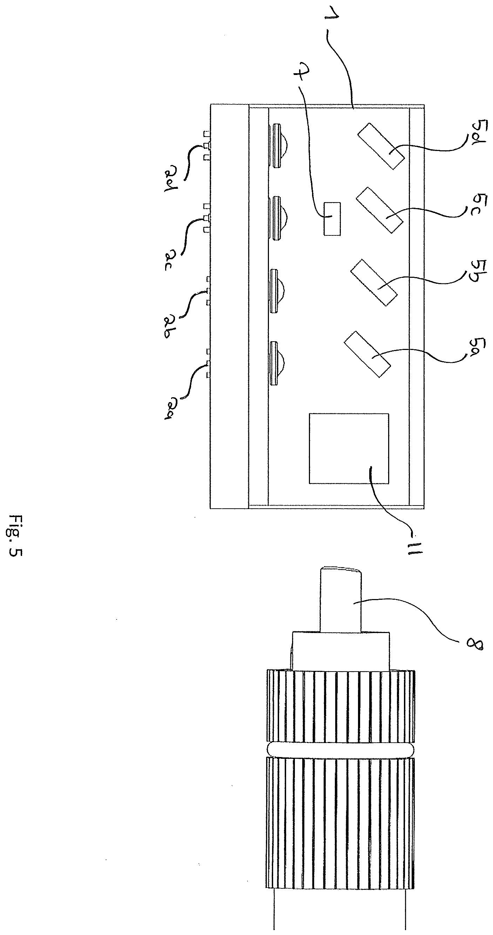

Figur 5 zeigt eine Ausführungsform einer erfindungsgemässen Vorrichtung analog zur Figur 2, wobei die austretenden Lichtstrahlen aus der Vorrichtung in eine Lichtleitfaser 8 eingekoppelt werden. Eine solche Vorrichtung kann insbesondere für medizinische Zwecke verwendet werden. Zusätzlich zu den in Figur 2 dargestellten Details umfasst die Vorrichtung ein Gehäuse mit einer Fokussierlinse 11, welches den austretenden Lichtstrahl in die Lichtleitfaser fokussiert.

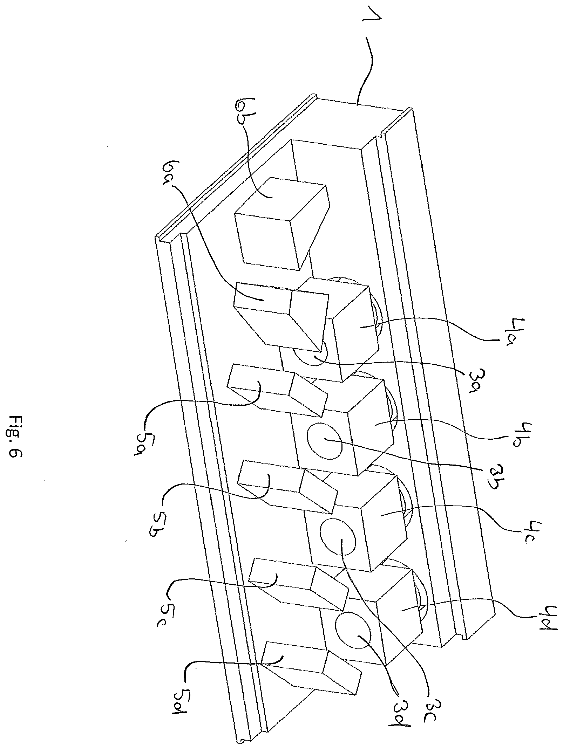

Figur 6 zeigt eine schematische dreidimensionale Ansicht einer erfindungsgemässen Vorrichtung. Das Gehäuse 1 umfasst vier Lichtquellen (nicht sichtbar). Vor den jeweiligen Lichtquellen sind Positionierungsmodule 4 angeordnet, in denen jeweils eine Kollimierungslinse 3 angeordnet ist. Mit Hilfe der Positionierungsmodule 4 ist die jeweilige Kollimierungslinse 3 so positioniert, dass eventuelle Fehler in der Ausrichtung der Lichtquelle bereits durch die Kollimierungslinse zumindest teilweise ausgeglichen werden. Nach dem Austritt aus dem Positionierungsmodul 4 werden die einzelnen Lichtstrahlen durch die dichroitischen Spiegel 5 umgelenkt und dann durch ein Prismenteleskop 6 in eine möglichst runde Form gebracht. Das Prismenteleskop 6 besteht aus einem ersten Prisma 6a und einem zweiten Prisma 6b die einzeln positionierbar sind. Somit lässt sich eine bessere Rundheit des Lichtstrahls erzielen.

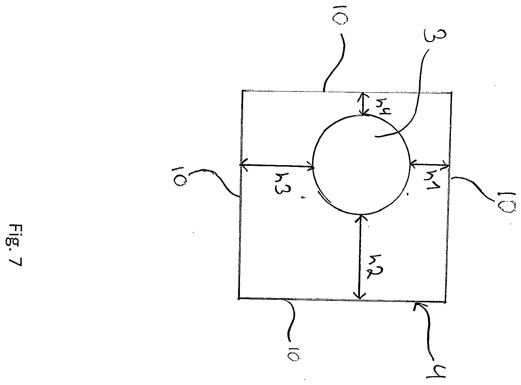

Figur 7 zeigt ein erfindungsgemässes Positionierungsmodul 4 mit vier Seitenflächen 10. Auf den Seitenflächen 10 kann das Positionierungsmodul 4 auf dem Boden 9 eines Gehäuses 1 (siehe Figur 1) festgelegt werden. Die Kollimierungslinse 3 ist exzentrische im Positionierungsmodul 4 positioniert. Die Abstände h1, h2, h3 und h4 unterscheiden sich somit voneinander und sind auf die Toleranzen der Emitterpositionen bei den unterschiedlichen Laserdioden abgestimmt.

## Patentansprüche

1. Vorrichtung zur Erzeugung von Licht mit mehreren Wellenlängen umfassend ein Gehäuse (1), im Gehäuse (1) angeordnete Lichtquellen (2), , Kollimierungslinsen (3) zum Kollimieren eines Lichtstrahls, der aus den Lichtquellen (2) austritt und Strahlführungselemente um die Lichtstrahlen zusammenzuführen, **dadurch gekennzeichnet, dass** die Kollimierungslinsen (3) in einem Positionierungsmodul (4) angeordnet sind, wobei die Kollimierungslinse (3) im Positionierungsmodul (4) exzentrisch bezogen auf die Seitenflächen des Positionierungsmoduls angeordnet ist, so dass die Kollimierungslinse (3) zur Korrektur eines eventuellen Ausrichtungsfehlers der Lichtquelle durch Drehen des Positionierungsmoduls (4) und Anordnen einer anderen Seitenfläche auf einem Boden (9) des Gehäuses (1) positionierbar ist, wobei das Positionierungsmodul (4) ein Würfel, ein sechsseitiges, ein acht- oder mehrseitiges Prisma ist.

2. Vorrichtung nach Anspruch 1, **wobei** die Lichtquellen (2) Laserdioden sind.

3. Vorrichtung nach Anspruch 1 oder 2, **wobei** im Gehäuse (1) drei Lichtquellen (2) mit jeweils unterschiedlichen Wellenlängen angeordnet sind.

4. Vorrichtung nach Anspruch 1, 2 oder 3, **dadurch gekennzeichnet, dass** die Strahlführungselemente dichroitische Spiegel (5) umfassen.

5. Vorrichtung nach Anspruch 4, **dadurch gekennzeichnet, dass** die Strahlführungselemente einen dichroitischen Spiegel (5) pro Lichtquelle umfassen.

6. Vorrichtung nach einem der vorhergehenden Ansprüche, **dadurch gekennzeichnet, dass** die Strahlführungselemente ein Prismenteleskop (6) umfassen.

7. Vorrichtung nach Anspruch 6, **dadurch gekennzeichnet, dass** das Prismenteleskop (6) aus einzelnen Prismen besteht, die zur optimalen Ausrichtung der Lichtstrahlen einzeln positionierbar sind.

8. Vorrichtung nach einem der vorhergehenden Ansprüche, **dadurch gekennzeichnet, dass** eine Lichtquelle (2) nach der Kollimierlinse in Strahlausbreitungsrichtung eine Verzögerungsplatte (7), bevorzugt eine λ/2-Platte, umfasst.

9. Verfahren zur Herstellung einer Vorrichtung, insbesondere gemäss Anspruch 1, umfassend die folgenden Schritte:
- Befestigen, von mindestens 3 Lichtquellen (2), insbesondere Laserdioden, in ein Gehäuse (1);
- Bereitstellen eines Positionierungsmoduls (4), wobei eine Kollimierungslinse (3) im Positionierungsmodul (4) exzentrisch bezogen auf die Seitenflächen des Positionierungsmoduls angeordnet ist und wobei das Positionierungsmodul (4) ein Würfel, ein sechsseitiges, ein acht- oder mehrseitiges Prisma ist;
- Positionieren von Kollimierungslinsen (3) in einem Lichtstrahl, der aus den jeweiligen Lichtquellen (2) austritt, mit Hilfe eines Positionierungsmoduls (3) durch Drehen des Positionierungsmoduls (4) und Anordnen einer anderen Seitenfläche auf einem Boden (9) des Gehäuses (1);
- Verbinden von Positionierungsmodul und Gehäuse, insbesondere als dauerhafte Verbindung;
- Positionieren von Strahlführungselementen in einem Lichtstrahl nach den Kollimierungslinsen (3) zum Zusammenführen der einzelnen Lichtstrahlen zu einem gemeinsamen Lichtstrahl.

10. Verfahren nach Anspruch 10, wobei die Lichtquellen (2) in das Gehäuse (1) eingepresst werden.

11. Verfahren nach Anspruch 10 oder 11, **dadurch gekennzeichnet, dass** die Strahlführungselemente dichroitische Spiegel (5) umfassen, wobei die Positionierungsmodule (3) so positioniert werden, dass eventuell vorhandene Höhenunterschiede der Strahlen auf den Spiegeln (5) zwischen den einzelnen Lichtstrahlen ausgeglichen werden.

12. Verwendung eines Positionierungsmoduls (4) zur Positionierung einer Kollimierungslinse (3) in einer Vorrichtung zur Erzeugung von Licht, wobei die Kollimierungslinse (3) im Positionierungsmodul (4) exzentrisch bezogen auf die Seitenflächen des Positionierungsmoduls angeordnet ist, wobei die Positionierung der Kollimierungslinse (3) durch Drehen des Positionierungsmoduls (4) und Anordnen auf einer anderen Seitenfläche auf einem Boden (9) eines Gehäuses (1) der Vorrichtung erfolgt, wobei das Positionierungsmodul (4) ein Würfel, ein sechsseitiges, ein acht- oder mehrseitiges Prisma ist.

13. Verfahren zur Kombination von Lichtstrahlen, **dadurch gekennzeichnet, dass** Lichtstrahlen aus mindestens zwei Lichtquellen (2) mit je einer Kollimierlinse (3) kollimiert werden, wobei die Kollimierlinsen (3) in je einem Positionierungsmodul (4) exzentrisch bezogen auf die Seitenflächen des Positionierungsmoduls angeordnet sind und durch Drehen des Positionierungsmoduls und Anordnen einer anderen Seitenfläche auf einem Boden (9) eines Gehäuses (1) der Vorrichtung positioniert werden, und Zusammenführen der kollimierten Strahlen zu einem kombinierten Strahl durch Strahlführungselemente, wobei das Positionierungsmodul (4) ein Würfel, ein sechsseitiges, ein acht- oder mehrseitiges Prisma ist.

14. Verfahren nach Anspruch 13, wobei die Lichtquellen (2), Laserdioden sind.

## Claims

1. A device for generating light with several wavelengths comprising a housing (1), light sources (2) arranged in the housing (1), collimating lenses (3) for collimating a light beam emerging from the light sources (2) and beam guiding elements for bringing the light beams together, **characterized in that** the collimating lenses (3) are arranged in a positioning module (4), the collimating lens (3) being arranged in the positioning module (4) eccentrically with respect to the side surfaces of the positioning module, so that the collimating lens (3) can be positioned to correct a possible alignment error of the light source by rotating the positioning module (4) and arranging another side surface on a bottom (9) of the housing (1), the positioning module (4) being a cube, a six-sided prism, an eight-sided prism or a multi-sided prism.

2. Device according to claim 1, wherein the light sources (2) are laser diodes.

3. Device according to claim 1 or 2, wherein three light sources (2) each having different wavelengths are arranged in the housing (1).

4. Device according to Claim 1, 2 or 3, **characterized in that** the beam guiding elements comprise dichroic mirrors (5).

5. Device according to claim 4, **characterized in that** the beam guiding elements comprise one dichroic mirror (5) per light source.

6. Device according to one of the preceding claims, **characterized in that** the beam guiding elements comprise a prism telescope (6).

7. Device according to claim 6, **characterized in that** the prism telescope (6) consists of individual prisms which can be positioned individually for optimum alignment of the light beams.

8. Device according to one of the preceding claims, **characterized in that** a light source (2) arranged downstream of the collimating lens in the beam propagation direction comprises a retarder plate (7), preferably a /2-plate.

9. Process for manufacturing a device, in particular according to claim 1, comprising the following steps:
- Fixing, in a housing (1), at least 3 light sources (2), in particular laser diodes;
- Providing a positioning module (4), wherein a collimating lens (3) in the positioning module (4) is arranged eccentrically relative to the side surfaces of the positioning module and wherein the positioning module (4) is a cube, a six-sided prism, an eight-sided prism or a multiple-sided prism;
- Positioning collimating lenses (3) in a light beam exiting the respective light sources (2) by means of a positioning module (3) by rotating the positioning module (4) and arranging another side surface on a bottom (9) of the housing (1);
- Connecting the positioning module to the housing, in particular as a permanent connection;
- Positioning of beam guiding elements in a light beam after the collimating lenses (3) for guiding the individual light beams together to form a common light beam.

10. Method according to claim 10, wherein the light sources (2) are pressed into the housing (1).

11. Method according to claim 10 or 11, **characterized in that** the beam guiding elements comprise dichroic mirrors (5), the positioning modules (3) being positioned in such a way that any height differences of the beams on the mirrors (5) between the individual light beams are compensated.

12. Use of a positioning module (4) for positioning a collimating lens (3) in a device for generating light, the collimating lens (3) being arranged in the positioning module (4) eccentrically relative to the side surfaces of the positioning module, the positioning of the collimating lens (3) being effected by rotating the positioning module (4) and arranging it on another side surface on a bottom (9) of a housing (1) of the device, the positioning module (4) being a cube, a six-sided prism, an eight-sided prism or a multi-sided prism

13. Method for combining light beams, **characterized in that** light beams from at least two light sources (2) are collimated with one collimating lens (3) each, the collimating lenses (3) being arranged in one positioning module (4) eccentrically relative to the side surfaces of the positioning module and being positioned on a base (9) of a housing (1) of the device by rotating the positioning module and arranging another side surface, and combining the collimated beams to a combined beam by beam guiding elements, wherein the positioning module (4) is a cube, a six-sided prism, an eight-sided prism or a multiple-sided prism.

14. Method according to claim 13, wherein the light sources (2) are laser diodes.

## Revendications

1. Dispositif de production de lumière à plusieurs longueurs d'onde, comprenant un bo tier (1), des sources de lumière (2) disposées dans le bo tier (1), des lentilles collimatrices (3) pour collimater un faisceau lumineux sortant des sources de lumière (2) et des éléments de guidage de faisceau pour rapprocher les faisceaux lumineux, **caractérisé en ce que** les lentilles collimatrices (3) sont disposées dans un module de positionnement (4), la lentille de collimation (3) étant disposée dans le module de positionnement (4) de manière excentrique par rapport aux surfaces latérales du module de positionnement de sorte que la lentille de collimation (3) peut être positionnée pour corriger un éventuel désalignement de la source lumineuse en tournant le module de positionnement (4) et en disposant une autre surface latérale sur un fond (9) du boîtier (1), le module de positionnement (4) étant un cube, un prismes à six côtés, un prismes à huit ou davantage.

2. Dispositif selon la revendication 1, dans lequel les sources lumineuses (2) sont des diodes laser.

3. Dispositif selon la revendication 1 ou 2, dans lequel trois sources de lumière (2) ayant chacune des longueurs d'onde différentes sont disposées dans le boîtier (1).

4. Dispositif selon la revendication 1, 2 ou 3, **caractérisé en ce que** les éléments de guidage de faisceau comprennent des miroirs dichroïques (5).

5. Dispositif selon la revendication 4, **caractérisé en ce que** les éléments de guidage de faisceau comprennent un miroir dichroïque (5) par source lumineuse.

6. Dispositif selon l'une des revendications précédentes, **caractérisé en ce que** les éléments de guidage de faisceau comprennent un télescope à prismes (6).

7. Dispositif selon la revendication 6, **caractérisé en ce que** le télescope à prismes (6) est constitué de prismes individuels qui peuvent être positionnés individuellement pour un alignement optimal des faisceaux lumineux.

8. Dispositif selon l'une des revendications précédentes, **caractérisé en ce qu'**une source lumineuse (2) suivant la lentille collimatrice comprend, dans la direction de propagation du faisceau, une plaque retardatrice (7), de préférence une plaque λ/2.

9. Procédé de fabrication d'un dispositif, notamment selon la revendication 1, comprenant les étapes suivantes :
Fixation, dans un boîtier (1), d'au moins 3 sources lumineuses (2), notamment des diodes laser ;
- Prévoir un module de positionnement (4), dans lequel une lentille de collimation (3) dans le module de positionnement (4) est disposée excentriquement par rapport aux surfaces latérales du module de positionnement et dans lequel le module de positionnement (4) est un cube, un prisme à six faces, un prisme à huit faces ou un prisme à plusieurs faces;
- Positionner des lentilles de collimation (3) dans un faisceau lumineux sortant des sources lumineuses respectives (2) au moyen d'un module de positionnement (3) en faisant tourner le module de positionnement (4) et en disposant une autre surface latérale sur un fond (9) du boîtier (1) ;
- Raccordement du module de positionnement au boîtier, en particulier en tant que raccordement fixe ;
- Positionnement d'éléments de guidage de faisceau dans un faisceau lumineux après les lentilles de collimation (3) pour guider les différents faisceaux lumineux ensemble pour former un faisceau lumineux commun.

10. Procédé selon la revendication 10, dans lequel les sources lumineuses (2) sont pressées dans le boîtier (1).

11. Procédé selon la revendication 10 ou 11, **caractérisé en ce que** les éléments de guidage de faisceau comprennent des miroirs dichroïques (5), les modules de positionnement (3) étant positionnés de telle sorte que les éventuelles différences de hauteur des faisceaux sur les miroirs (5) entre les différents faisceaux lumineux soient compensées.

12. Utilisation d'un module de positionnement (4) pour positionner une lentille de collimation (3) dans un dispositif de génération de lumière, la lentille de collimation (3) étant disposée dans le module de positionnement (4) de manière excentrique par rapport aux surfaces latérales du module de positionnement, le positionnement de la lentille de collimation (3) étant effectué en faisant tourner le module de positionnement (4) et en le disposer sur une autre surface latérale sur un fond (9) d'un boîtier (1) du dispositif, le module de positionnement (4) étant un cube, un prisme à six côtés, un prisme à huit côtés ou un prisme multiface.

13. Procédé pour combiner des faisceaux lumineux, **caractérisé en ce que** des faisceaux lumineux provenant d'au moins deux sources lumineuses (2) sont collimatés avec une lentille de collimation (3) chacune, les lentilles de collimation (3) étant disposées dans un module de positionnement (4) excentriquement par rapport aux surfaces latérales du module de positionnement et étant placées sur une base (9) d'un boîtier (1) du dispositif en tournant le module de positionnement et en disposant une autre surface latérale, et la combinaison des faisceaux collimatés en un faisceau combiné par des éléments de guidage de faisceau, dans lequel le module de positionnement (4) est un cube, un prisme à six côtés, un prisme à huit côtés ou un prisme à plusieurs côtés.

14. Procédé selon la revendication 13, dans lequel les sources lumineuses (2) sont des diodes laser.
